# EUROPÄISCHE PATENTSCHRIFT

(11) **EP 3 091 100 B1**
(45) Veröffentlichungstag und Bekanntmachung des Hinweises auf die Patenterteilung: **19.02.2020**
(21) Anmeldenummer: 16176352.9
(22) Anmeldetag: 13.10.2011
(51) Int. Cl.: C23C 14/06, C23C 14/08, C23C 30/00, F16J 9/26, H01J 37/32, C23C 14/32, C23C 14/02, C23C 28/00

(54) **GLEITELEMENT, INSBESONDERE KOLBENRING, MIT EINER BESCHICHTUNG SOWIE VERFAHREN ZUR HERSTELLUNG EINES GLEITELEMENTS**
SLIDING ELEMENT, IN PARTICULAR A PISTON RING, HAVING A COATING AND METHOD FOR PRODUCING A SLIDING ELEMENT
COULISSEAU, EN PARTICULIER BAGUE DE PISTON COMPRENANT UN REVETEMENT ET PROCEDE DE FABRICATION D'UN COULISSEAU

(30) Priorität: 27.01.2011 DE 102011003254
(43) Veröffentlichungstag der Anmeldung: 09.11.2016
(62) Teilanmeldung aus: 11768014.0
(73) Patentinhaber: Federal-Mogul Burscheid GmbH, 51399 Burscheid (DE)
(72) Erfinder: Kennedy, Marcus, 40477 Düsseldorf (DE)
(74) Vertreter: Hoffmann Eitle

(56) Entgegenhaltungen:
- WO-A1-2007/020139
- WO-A2-2011/110411
- DE-A1-102007 060 091
- US-A1- 2008 053 396
- Manier, C-A: "Slip-rolling resistance of novel Zr(C,N) thin film coatings under high Hertzian contact pressures", BAM-Dissertationsreihe, Bd. 60 11. Februar 2010 (2010-02-11), Seiten 1-138, XP055013961, Bundesanstalt für Materialforschung und -prüfung, Berlin [DE] ISBN: 978-3-98-135503-1 Gefunden im Internet: URL:http://www.bam.de/de/service/publikati onen/publikationen_medien/dissertationen/d iss_60_vt.pdf [gefunden am 2011-12-06]
- ERYILMAZ O ET AL: "The effect of the sputter cleaning of steel substrates with neutral molecule source on the adhesion of TiN films", SURFACE AND COATINGS TECHNOLOGY, Bd. 97, Nr. 1-3, Dezember 1997 (1997-12), Seiten 488-491, XP027367687, ELSEVIER, AMSTERDAM [NL] ISSN: 0257-8972, DOI: 10.1016/S0257-8972(97)00189-8 [gefunden am 1997-12-01]
- SCHEIBE H ET AL: "Laser-induced vacuum arc (Laser Arc) and its application for deposition of hard amorphous carbon films", SURFACE AND COATINGS TECHNOLOGY, Bd. 74-75, Nr. Part 2, Oktober 1995 (1995-10), Seiten 813-818, XP055013859, Elsevier, Amsterdam [NL] ISSN: 0257-8972, DOI: 10.1016/0257-8972(95)08280-8

## Beschreibung

### Technisches Gebiet

Die Erfindung betrifft ein Gleitelement, insbesondere einen Kolbenring mit einer Beschichtung auf zumindest einer Lauffläche sowie ein Verfahren zur Herstellung eines Gleitelements.

Gleitelemente, wie z.B. Kolbenringe, Kolben oder Zylinderlaufbuchsen in Verbrennungsmotoren müssen über eine lange Lebensdauer sowohl bei möglichst geringer Reibung als auch mit geringem Verschleiß arbeiten. Zwar kann die Reibung, die bei Verbrennungsmotoren unmittelbar mit dem Kraftstoffverbrauch einhergeht, durch Beschichtungen aus DLC (diamond-like carbon) gering gehalten werden. Ferner können grundsätzlich Schichtdicken bis 40 µm erreicht werden. Jedoch ergibt sich bei Schichtdicken von mehr als 5 µm das Problem, dass sich die Schichteigenschaften, beispielsweise im Hinblick auf den Aufbau und die Zusammensetzung der Schicht, verändern, so dass die geforderte Lebensdauer nicht erreicht wird. Dies gilt in gleicher Weise für Schichtdicken von weniger als 5 um.

Ziel dieser Erfindung ist es, ein Gleitelement mit einer metallhaltigen Haftschicht sowie einer DLC-Beschichtung des Typs ta-C mit einer geeigneten Schichtdicke darzustellen, um minimale Reibleistungsverluste während der gesamten Lebensdauer des Bauteil zu gewährleisten.

### Stand der Technik

Diamantähnliche Kohlenstoffschichten (DLC) sind eine metastabile Form von amorphem Kohlenstoff mit einem signifikanten Anteil an sp³-hybridisiertem Kohlenstoff. Die Darstellung von diamantähnlichen Kohlenstoffschichten auf unterschiedlichen Subtraten zur Entwicklung von neuen Bauteilen erfolgt heutzutage mittels unterschiedlichen Prozessen. Die bekanntesten Prozesse, mit denen serienfähige Gleitelemente beschichtet werden können, sind der PA-CVD, das Sputtern sowie der Vakuum Lichtbogenverdampfungsprozess (DE4006456). Die dadurch darstellbaren Schichtsysteme sind üblicherweise wasserstoffhaltig, bei PA-CVD, sowie wasserstofffrei beim Sputtern oder dem Vakuum Lichtbogenverdampfungsprozess. Eine Zusammenfassung der möglichen DLC Schichtsysteme findet sich in der VDI Richtlinie 2840 *Kohlenstoffschichten.*

Tabelle 1 listet die Dokumente auf, die im Rahmen dieser Anmeldung zur Darstellung des Stands der Technik beitragen. In der Auflistung wird zwischen Prozess- und Produktrelevanten Druckschriften unterschieden.

| **Nummer** | **Jahr** | **Typ** | **Wichtige Merkmale** |
|---|---|---|---|
| DE 3901401 | 1989 | DLC Herstellung / Prozess | Methode zur Kontrolle eines Vakuum Lichtbogenverdampfungsprozesses |
| DE 4006456 | 1990 | | Verfahren zur Steuerung einer Vakuumlichtbogenentladung |
| DE 10240337 | 2002 | | Vorrichtung zur Separation von Partikeln, bei dem die Absorberelektrode im Schatten des erzeugten Plasmas angeordnet ist und zur Beschleunigung positiver Ladungsträger ein (elektro-)magnetisches Feld ausqebildet ist. |
| DE 19850217 / US 6558757 | 1998 | | Vakuumbeschichtungsprozess, bei dem mittels eines Lasers aus einem Target Material ionisiert und mit einem Gas, das in den Poren eingelagert ist, reagiert und anschließend auf einem Substrat abgeschieden wird. |
| EP 1829986 | 2010 | | Verfahren zur Bearbeitung von Oberflächen mit einer Beschichtung aus hartem Kohlenstoff |
| EP 0724023 | 1996 | DLC Produkt | Harte, amorphe, wasserstofffreie Kohlenstoffschicht (< 0,5 at% H, E-Modul > 400 GPa, Härte > 40 GPa, maximale Schichtdicke: wenige µm, hergestellt mittels Vakuum Lichtboqen |
| DE 102005063123B3 | 2005 | | Gleitelement mit Verschleißschutz und Einlaufschicht, wobei die Einlaufschicht Wasserstoff und nanokristalline Karbidphasen enthält. |
| DE 102008016864B3 | 2008 | | Kolbenring mit einer DLC-Beschichtung mit 3-lagigem Schichtsystem: Haftschicht, metallhaltige amorphe Kohlenstoffschicht, metallfreie amorphe Kohlenstoffschicht, Widerstand > 5000 Ohm |
| US 6231956 | 1997 | | Verschleißfestes Schichtsystem, bestehend aus einem Substrat aus einer Titanlegierung, einer Zwischenschicht sowie einer amorphen Kohlenstoffschicht |
| DE 19735962A1 | 1997 | | Führungsbuchse mit wasserstoffhaltiger DLC-Innenbeschichtung |
| DE 19850218 | 1998 | | Vorrichtung und Verfahren zur Beschichtung von Substraten im Vakuum mit einer speziellen Absorberelektrode, die so angeordnet ist, dass die Teilchen nicht direkt auf dem Substrat abgeschieden werden. |
| WO 2006125683A1 | 2006 | | Kolbenring mit einem 3-lagigen Schichtsystem, bestehend aus einer 1. Schicht aus der Gruppe IVB, VB oder VIB (< 1µm), einer 2. Schicht aus einem diamant-ähnlichem Nanokomposit (< 5µm) und einer 3. Schicht aus einer diamant-ähnlichen Schicht (Schichtdicke 0,1µm-10µm) |
| DE 102008022039 | 2008 | | Verschleißschutzbeschichtung aus amorpher Kohlenstoffschicht mit einem Sauerstoffanteil von 0,5at% - 25at%. |

Aus der EP 0724023 ist eine wasserstofffreie (< 0,5at%) DLC-Beschichtung mit gutem Reibungsverhalten unter nicht geschmierten Bedingungen sowie unter reduziertem Schmiermitteleinsatz bekannt. Diese Schicht hat eine Härte von > 40 GPa sowie ein E-Modul von > 400 GPa bei einer maximalen Dicke von wenigen um.

Aus der DE 10 2005 063 123 B3 ist ein Gleitelement mit einer DLC-Beschichtung mit gutem Einlaufverhalten bekannt. Durch die zu geringe Lebensdauer kann eine dauerhaft niedrige Reibung nicht über die gesamte Lebensdauer des Gleitelements gewährleistet sein.

Die DE 10 2008 016 864 betrifft ein Gleitelement mit einer mehrlagigen Beschichtung, die von innen nach außen eine Haftschicht, eine metall- und wasserstoffhaltige DLC-Schicht und eine metallfreie wasserstoffhaltige DLC-Schicht aufweist.

Aus der DE 197 35 962 A1 geht eine Führungsbuchse und ein Verfahren zur Ausbildung eines harten Kohlenstofffilms auf der Innenfläche der Führungsbuchse hervor, bei dem auf der Innenfläche ein harter Kohlenstofffilm aus hydriertem, amorphen Kohlenstoff durch ein Plasma-CVD-Verfahren ausgebildet wird.

Die WO 2006/125683 A1 zeigt einen Kolbenring, der von innen nach außen eine Schicht mit einem Element der Gruppen IVB, VB oder VIB, eine Zwischenschicht mit einer diamantartigen Nanokomposit-Zusammensetzung und eine DLC-Schicht aufweist.

Es ist bekannt, dass gute Verschleißwerte erreicht werden, wenn der Anteil an sp3-hybridisierten Kohlenstoffatomen möglichst hoch, insbesondere größer als 60 At% ist. Derartige Schichten werden als ta-C-Schichten bezeichnet und können durch herkömmliche Sputtervorgänge oder sogenannte Vakuum-Arc-Prozesse realisiert werden (vgl. hierzu DE 40 40 456 C1 und DE 198 50 218 C1 aus Tabelle 1). Wasserstofffreie ta-C-Beschichtungen können mit einer Dicke von wenigen Mikrometern als sauerstoffhaltige (vgl. beispielsweise die Lehre der DE 10 2008 022 039 A1 aus Tabelle 1) und als sauerstoff- und wasserstofffreie Schichten hergestellt werden (vgl. hierzu EP 0 724 023 A1).

Bekannt sind in diesem Zusammenhang ferner PVD-Beschichtungen auf Hartstoffbasis, die zumeist Chromnitrid aufweisen.

Derartige Schichten haben zwar die erforderliche Verschleißbeständigkeit, nicht jedoch den notwendigen niedrigen Reibkoeffizienten.

Weiterer Stand der Technik findet sich in WO 2011/110411 A2, worin ein Verfahren zur Beschichtung zumindest der Innenflächen eines Kolbenrings sowie ein Kolbenring beschrieben wird, und WO 2007/020139 A1, welche ein Substrat beschreibt, das mit einer Schichtstruktur beschichtet ist, wobei die Schichtstruktur eine tetrahedrale Kohlenstoffschicht und eine weiche Außenschicht aufweist.

### Darstellung der Erfindung

Die vorliegende Erfindung wird definiert durch die unabhängigen Ansprüche 1, 11 und 12. Die entsprechenden abhängigen Ansprüche 2 bis 10 und 13 bis 16 beschreiben optionale Merkmale und bevorzugte Ausführungsformen.

Vor diesem Hintergrund liegt der Erfindung die Aufgabe zugrunde, ein Gleitelement zur Verfügung zu stellen, das im Hinblick auf die Kombination aus Reibungskoeffizienten und Verschleißeigenschaften weiter verbessert ist. Ferner soll ein Verfahren zur Herstellung eines derartigen Gleitelements geschaffen werden.

Demzufolge weist das erfindungsgemäße Gleitelement auf zumindest einer Lauffläche von innen nach außen eine Beschichtung mit einer metallhaltigen Haftschicht und einer DLC-Schicht des Typs ta-C mit einer Dicke von mindestens 10 µm auf. Die metallhaltige Haftschicht sorgt in vorteilhafter Weise nicht nur für eine Haftung der DLC-Schicht, sondern kann auch die in dieser Schicht auftretenden Eigenspannungen ausgleichen. Die Mindestschichtdicke von 10 µm sorgt für die erforderliche Verschleißbeständigkeit und ermöglicht darüber hinaus gute Reibungswerte über die Motorlebensdauer. Insbesondere kann das Verschleißverhalten sowohl auf dem Gleitelement, insbesondere auf dem Kolbenring selbst, als auch an dem Gegenkörper, wie z.B. der Zylinderlaufbuchse eingestellt werden. Die Herstellbarkeit der erfindungsgemäßen Beschichtung wird durch die nachfolgend beschriebenen Verfahrensschritte, insbesondere die Reinigung der zu beschichtenden Oberfläche durch ein Metallionensputterverfahren, sowie die beschriebenen Herstellungsverfahren für die Haft- und die DLC-Schicht gewährleistet. Folglich kann ein deutlich verbessertes Gleitelement bereitgestellt werden.

Eine der zentralen Anforderungen an das Gleitelement, insbesondere den Kolbenring, besteht in der Bereitstellung einer lebensdauerfähigen Beschichtung, um während des gesamten Betriebs möglichst geringe Reibleistungsverluste zu gewährleisten. In ersten motorischen Validierungen wurde festgestellt, dass zwar für das System taC-beschichteter Kolbenring / AlSi Laufbahn ein im Vergleich zu wasserstoffhaltigen DLC-beschichteten Kolbenringen um 60% geringerer Verschleiß erreicht wurde, aber je nach Anwendung und Laufpartner eine Schichtdicke von mindestens 10µm notwendig ist. Die Dicke der gesamten Beschichtung beträgt bevorzugt bis zu etwa 20 µm.

In außermotorischen Voruntersuchungen wurde festgestellt, dass die Maßnahme, wonach die randnahen äußeren 1 µm bis 3 µm dotiert wurden, zu einer weiteren Verbesserung hinsichtlich thermischer Beständigkeit und des Brandspurverhaltens unter Mangelschmierbedingungen unter Grenzlasten bis zu 700N führt.

Um insbesondere bei ta-C Schichtdicken größer als wenige µm eine ausreichende Schichthaftung zu gewährleisten, ist es ferner notwendig, eine metallhaltige Haftschicht zwischen Substrat und DLC-Schicht darzustellen. Für die Haftschicht wird derzeit aufgrund erster Erkenntnisse bevorzugt, dass diese mindestens einer der folgenden Materialien enthält: Chrom, Titan, Chromnitrid und Wolfram.

Ferner hat sich für die Haftschicht eine Dicke von 0,1 µm bis 1,0 µm als vorteilhaft erwiesen.

Besonders gute Eigenschaften wurden ferner festgestellt, wenn die DLC-Schicht im Wesentlichen sauerstoff- und/oder wasserstofffrei ist, d.h. einen Anteil dieser Elemente von weniger als jeweils 0,5 At% aufweist.

Ebenfalls hat die Härte und das E-Modul der DLC-Schicht einen Einfluss auf das tribologische Verhalten des Kolbenrings. Im Rahmen der Untersuchungen ergibt sich in vorteilhafter Weise für die Beschichtung eine Oberflächenhärte von maximal 55 GPa bei einem E-Modul von maximal 550 GPa.

Im Gegensatz zum Stand der Technik wurde in außermotorischen sowie motorischen Validierungen ferner festgestellt, dass besonders gute Verschleißwerte bereits erreicht werden, wenn die DLC-Schicht einen sp3-Anteil von hybridisierten Kohlenstoffatomen von mindestens 40 At% aufweist.

Eine gezielte Reduzierung des sp³-Anteils in den randnahen äußeren 1 µm bis 3 µm der Schicht führt zu einer weiteren Reduzierung der Reibung im Einlauf sowie der Einlaufzeit selbst.

Der randnahe äußere Bereich der DLC-Schicht mit einer Dicke von 1 µm bis 3 µm ist in erfindungsgemäßer Weise mit Bor, Sauerstoff und/oder Silizium dotiert.

Insbesondere für die Gewährleistung eines geringen Reibwerts ist eine möglichst glatte Lauffläche des Gleitelements notwendig. Die hier vorgestellte DLC-Schicht weist bevorzugt im beschichteten Zustand eine Rauhtiefe von Rz<6µm sowie im endbearbeiteten Zustand eine Rauhtiefe von Rz<2µm, insbesondere < 1 µm, sowie eine reduzierte Spitzentiefe von Rpk < 0,3µm, insbesondere < 0,1µm auf. In diesem Zusammenhang wird auf die Maßnahmen aus der EP 1 829 986 A1 und DE 198 50 218 C1 verwiesen.

Für das Substrat und Grundmaterial des zu beschichtenden Gleitelements wird Gusseisen oder Stahl bevorzugt, das/der für bestimmte Anwendungsfälle nitriert sein kann. Hinsichtlich Guss als Grundmaterial sind die bevorzugten Ausführungsformen:
- Unlegiertes, unvergütetes Gusseisen mit Lamellargraphit
- Legierter, wärmebehandelter oder nicht wärmebehandelter Grauguss mit Karbiden
- Sphäroguss vergütet
- Vermiculargraphitguss unvergütet
- Stahlguss (mindestens 11 Gew% Chrom, angelassene Martensitstruktur mit eingelagerten Sonderkarbiden, nitriert oder nicht nitriert)

Hinsichtlich Stahl als Grundmaterial sind die bevorzugten Ausführungsformen:
- Chrom-Stahl, mindestens 11 Gew% Chrom, nitriert oder nicht nitriert
- Chrom-Silizium-Kohlenstoffstahl

Motorische Untersuchungen haben ergeben, dass eine besonders gute Ölabstreifwirkung des mit der erfindungsgemäßen DLC-Schicht des Typs ta-C beschichteten Kolbenrings durch sehr kleine, "scharfe" untere Laufkanten erreichen wird. Daher ist es für die untere Laufflächenkante eines erfindungsgemäßen Kolbenrings erforderlich, dass diese einen Radius von maximal 0,2 mm, bevorzugt weniger als 0,1 mm aufweist.

Die Lösung der oben genannten Aufgabe erfolgt ferner durch das im Anspruch 12 beschriebene Verfahren zur Herstellung eines Gleitelements, insbesondere eines Kolbenrings, bei dem eine Beschichtung mit einer metallhaltigen Haftschicht und einer DLC-Schicht des Typs ta-C in einer Dicke von mindestens 10 µm erfolgt. Das bereits durch verschiedene Dokumente (s. Tabelle 1) beschriebene Herstellungsverfahren des Vakuum-Laser-Arc Verfahrens wurde im Rahmen dieser Erfindung für die Herstellung von ta-C Schichten >10µm insofern verbessert, dass eine optimierte Haftschicht hinsichtlich Materialauswahl und Schichtdicke verwendet wurde sowie die Prozessparameter eine Prozessstabilität über die gesamte Beschichtungsdauer gewährleisten. Bevorzugte Maßnahmen sowie die durch das Verfahren erreichbaren Vorteile ergeben sich zum einen aus der vorangehenden Beschreibung des erfindungsgemäßen Gleitelements. Bei dieser Gelegenheit sei ferner erwähnt, dass sämtliche nachfolgend im Zusammenhang mit dem Verfahren angegebenen Merkmale auch auf das erfindungsgemäße Gleitelement angewendet werden können.

Zum anderen sei erwähnt, dass die Haftschicht besonders zuverlässig durch ein Sputter-, ein thermisches Verdampfungsverfahren oder ein elektrisches Verdampfungsverfahren, wie z.B. ein Are-Verfahren ausgebildet werden kann.

Wie oben erwähnt, bietet es für die Haftung der Haftschicht auf dem Substrat des Gleitelements besondere Vorteile, wenn die zu beschichtende Oberfläche durch ein Metallionensputterverfahren gereinigt wird.

Die Rauheit der fertig ausgebildeten Beschichtung kann in vorteilhafter Weise durch Läppen, Band- und/oder Bürstpolieren verringert werden.

## Patentansprüche

1. Gleitelement, insbesondere Kolbenring, das/der auf zumindest einer Lauffläche von innen nach außen eine Beschichtung mit einer metallhaltigen Haftschicht und einer DLC-Schicht des Typs ta-C mit einer Dicke von mindestens 10 µm aufweist, wobei die äußeren 1 µm bis 3 µm der ta-C-Schicht mit mindestens einem der folgenden Elemente dotiert sind: Bor, Sauerstoff und/oder Silizium.

2. Gleitelement nach Anspruch 1,
**dadurch gekennzeichnet, dass**
die Haftschicht mindestens eines der folgenden Materialien enthält: Chrom, Titan, Chromnitrid und/oder Wolfram.

3. Gleitelement nach Anspruch 1 oder 2,
**dadurch gekennzeichnet, dass**
die Haftschicht eine Dicke von 0,1 µm bis 1,0 µm aufweist.

4. Gleitelement nach einem der vorangehenden Ansprüche,
**dadurch gekennzeichnet , dass**
die ta-C-Schicht Sauerstoff und/oder Wasserstoff mit einem Anteil von weniger als 0,5 At% aufweist.

5. Gleitelement nach einem der vorangehenden Ansprüche,
**dadurch gekennzeichnet , dass**
die Härte maximal 55 GPa und das E-Modul maximal 550 GPa betragen.

6. Gleitelement nach einem der vorangehenden Ansprüche,
**dadurch gekennzeichnet , dass**
die ta-C-Schicht einen sp3-Anteil von hybridisierten Kohlenstoffatomen von mindestens 40 At% aufweist.

7. Gleitelement nach Anspruch 6,
**dadurch gekennzeichnet, dass**
der sp3-Anteil in den äußeren 1 µm bis 3 µm der Schicht reduziert ist.

8. Gleitelement nach einem der vorangehenden Ansprüche,
**dadurch gekennzeichnet , dass**
die Beschichtung eine Rautiefe Rz von < 6 µm, bevorzugt < 2 µm und insbesondere < 1 µm aufweist.

9. Gleitelement nach einem der vorangehenden Ansprüche,
**dadurch gekennzeichnet , dass**
die Beschichtung eine reduzierte Spitzentiefe Rpk von < 0,3 µm, bevorzugt < 0,1 µm aufweist.

10. Gleitelement nach einem der vorangehenden Ansprüche,**dadurch gekennzeichnet, dass** das Grundmaterial Gusseisen oder Stahl ist.

11. Kolbenring nach einem der vorangehenden Ansprüche,
**dadurch gekennzeichnet , dass**
der Radius der unteren Laufflächenkante maximal 0,2 mm und bevorzugt < 0,1 mm beträgt.

12. Verfahren zur Herstellung eines Gleitelements, insbesondere eines Kolbenrings, nach einem der Ansprüche 1 bis 11 bei dem eine Beschichtung mit einer metallhaltigen Haftschicht und einer DLC-Schicht des Typs ta-C in einer Dicke von mindestens 10 µm erfolgt.

13. Verfahren nach Anspruch 12,
**dadurch gekennzeichnet, dass**
die Haftschicht durch ein Sputter-, ein thermisches Verdampfungsverfahren oder ein elektrisches Verdampfungsverfahren, wie z.B. ein Arc-Verfahren ausgebildet wird.

14. Verfahren nach Anspruch 12 oder 13,
**dadurch gekennzeichnet, dass**
die ta-C-Schicht mittels eines Vakuum-Laser-Arc-Verfahrens ausgebildet wird.

15. Verfahren nach einem der Ansprüche 12 bis 14,
**dadurch gekennzeichnet, dass**
die zu beschichtende Oberfläche mittels eines Metallionensputterverfahrens gereinigt wird.

16. Verfahren nach einem der Ansprüche 12 bis 15,
**dadurch gekennzeichnet , dass**
die Beschichtung nach ihrer Ausbildung durch Läppen, Band- und/oder Bürstpolieren geglättet wird.

## Claims

1. Sliding element, in particular piston ring, which on at least one running surface from the inside to the outside has a coating with a metal-containing adhesive layer and a DLC layer of the type ta-C having a thickness of at least 10 µm, wherein the outer 1 µm to 3 µm of the ta-C layer are doped with at least one of the following elements: boron, oxygen and/or silicon.

2. Sliding element according to claim 1, **characterised in that** the adhesive layer contains at least one of the following materials: chromium, titanium, chromium nitride and/or tungsten.

3. Sliding element according to claim 1 or 2, **characterised in that** the adhesive layer has a thickness of 0.1 µm to 1.0 µm.

4. Sliding element according to one of the preceding claims, **characterised in that** the ta-C layer has oxygen and/or hydrogen with a content of less than 0.5 at%.

5. Sliding element according to one of the preceding claims, **characterised in that** the hardness is 55 GPa at the most and the modulus of elasticity is 550 GPa at the most.

6. Sliding element according to one of the preceding claims, **characterised in that** the ta-C layer has an sp3 content of hybridised carbon atoms of at least 40 at%.

7. Sliding element according to Claim 6, **characterised in that** the sp3 content in the outer 1 µm to 3 µm of the layer is reduced.

8. Sliding element according to one of the preceding claims, **characterised in that** the coating has a roughness depth Rz of < 6 µm, preferably < 2 µm and in particular < 1 µm.

9. Sliding element according to one of the preceding claims, **characterised in that** the coating has a reduced peak depth Rpk of < 0.3 µm, preferably < 0.1 µm.

10. Sliding element according to one of the preceding claims, **characterised in that** the base material is cast iron or steel.

11. Piston ring according to one of the preceding claims, **characterised in that** the radius of the lower running surface edge is 0.2 mm at the most and preferably < 0.1 mm.

12. Method for producing a sliding element according to one of claims 1 to 11, in particular a piston ring, in which a coating with a metal-containing adhesive layer and a DLC layer of the type ta-C is effected in a thickness of at least 10 µm.

13. Method according to claim 12, **characterised in that** the adhesive layer is formed by a sputtering method, a thermal evaporation method or an electrical evaporation method, such as for example an arc method.

14. Method according to claim 12 or 13, **characterised in that** the ta-C layer is formed by means of a vacuum-laser-arc method.

15. Method according to one of claims 12 to 14, **characterised in that** the surface to be coated is cleaned by means of a metal ion-sputtering method.

16. Method according to one of claims 12 to 15, **characterised in that** the coating is smoothed after its formation by lapping, belt-polishing and/or brush-polishing.

## Revendications

1. Élément de glissement, en particulier segment de piston, qui présente sur au moins une surface de contact, de l'intérieur vers l'extérieur, un revêtement avec une couche adhésive contenant du métal et une couche DLC du type ta-C d'une épaisseur d'au moins 10 µm, dans lequel les 1 µm à 3 µm extérieurs de la couche ta-C sont dopés avec au moins un des éléments suivants : bore, oxygène et/ou silicium.

2. Élément de glissement selon la revendication 1,
**caractérisé en ce que** la couche adhésive contient au moins l'un des matériaux suivants : chrome, titane, nitrure de chrome et/ou tungstène.

3. Élément de glissement selon la revendication 1 ou 2,
**caractérisé en ce que** la couche adhésive présente une épaisseur de 0,1 µm à 1,0 µm.

4. Élément de glissement selon l'une quelconque des revendications précédentes,
**caractérisé en ce que** la couche ta-C présente de l'oxygène et/ou de l'hydrogène avec une teneur de moins de 0,5 % at.

5. Élément de glissement selon l'une quelconque des revendications précédentes,
**caractérisé en ce que** la dureté vaut au maximum 55 GPa et le coefficient d'élasticité vaut au maximum 550 GPa.

6. Élément de glissement selon l'une quelconque des revendications précédentes,
**caractérisé en ce que** la couche ta-C présente une teneur sp3 d'atomes de carbone hybridés d'au moins 40 % at.

7. Élément de glissement selon la revendication 6,
**caractérisé en ce que** la teneur sp3 est réduite dans les 1 µm à 3 µm extérieurs de la couche.

8. Élément de glissement selon l'une quelconque des revendications précédentes,
**caractérisé en ce que** le revêtement présente une profondeur de rugosité Rz de < 6 µm, de préférence < 2 µm et en particulier < 1 µm.

9. Élément de glissement selon l'une quelconque des revendications précédentes,
**caractérisé en ce que** le revêtement présente une profondeur de pics réduite Rpk de < 0,3 µm, de préférence < 0,1 µm.

10. Élément de glissement selon l'une quelconque des revendications précédentes,
**caractérisé en ce que** le matériau de base est de la fonte ou de l'acier.

11. Segment de piston selon l'une quelconque des revendications précédentes,
**caractérisé en ce que** le rayon de l'arête de surface de contact inférieure vaut au maximum 0,2 mm et de préférence < 0,1 mm.

12. Procédé de fabrication d'un élément de glissement selon l'une quelconque des revendications 1 à 11, en particulier d'un segment de piston, selon lequel on effectue un revêtement avec une couche adhésive contenant du métal et une couche DLC du type taC d'une épaisseur d'au moins 10 µm.

13. Procédé selon la revendication 12,
**caractérisé en ce que** la couche adhésive est réalisée par un procédé de pulvérisation, un procédé de vaporisation thermique ou un procédé de vaporisation électrique, par exemple un procédé à arc électrique.

14. Procédé selon la revendication 12 ou 13,
**caractérisé en ce que** la couche ta-C est réalisée au moyen d'un procédé à arc laser sous vide.

15. Procédé selon l'une quelconque des revendications 12 à 14,
**caractérisé en ce que** la surface à revêtir est nettoyée au moyen d'un procédé de pulvérisation à ions métalliques.

16. Procédé selon l'une quelconque des revendications 12 à 15,
**caractérisé en ce que**, après sa réalisation, le revêtement est lissé par rodage, par polissage à la bande et/ou par polissage à la brosse.
